# EUROPÄISCHE PATENTSCHRIFT

(11) **EP 2 458 633 B1**
(45) Veröffentlichungstag und Bekanntmachung des Hinweises auf die Patenterteilung: **14.12.2016**
(21) Anmeldenummer: 11185539.1
(22) Anmeldetag: 18.10.2011
(51) Int. Cl.: H01L 23/473, H05K 7/20

(54) **Leistungshalbleitersystem**
Power semiconductor
Système semi-conducteur de puissance

(30) Priorität: 05.11.2010 DE 102010043446
(43) Veröffentlichungstag der Anmeldung: 30.05.2012
(73) Patentinhaber: SEMIKRON Elektronik GmbH & Co. KG, 90431 Nürnberg (DE)
(72) Erfinder: Beckedahl, Peter, 90522 Oberasbach (DE); Kulas, Hartmut, 91320 Ebermannstadt (DE); Ebersberger, Frank, 90518 Altdorf (DE)

(56) Entgegenhaltungen:
- EP-A1- 0 618 618
- EP-A1- 1 843 392
- EP-A2- 1 124 259
- DE-A1-102008 016 960
- US-A1- 2001 014 029
- US-A1- 2005 083 652
- US-A1- 2008 130 223
- US-A1- 2009 219 694
- US-A1- 2010 053 889
- US-A1- 2010 208 427
- US-B1- 6 892 796

## Beschreibung

Die vorliegende Erfindung betrifft ein Leistungshalbleitersystem ausgehend von bekannten Leistungshalbleitermodulen.

Leistungshalbleitermodule sind in verschiedenen Ausführungsformen bekannt. In einer typischen Ausführungsform werden ein Substrat mit einer Leistungshalbleiterschaltung und ein Grundkörper zu einem Leistungshalbleitermodul zusammengebaut. Hierbei ist darauf zu achten, dass der Wärmeübergang zwischen Leistungshalbleiterschaltung, Grundkörper und einem hierzu angeordneten Kühlkörper den erwünschten Abtransport von Abwärme aus der Leistungshalbleiterschaltung gewährleistet ist, und dass eine einfache, vorzugsweise eine automatisierte, Montage des Leistungshalbleitermoduls möglich ist.

Zum Beispiel beschreibt DE 10 2005 037 522 ein Leistungshalbleitermodul zur Montage auf einem Kühlkörper, wobei das Leistungshalbleitermodul einen metallischen Grundkörper aufweist, der eine Wanne bildet und ein darin angeordnetes, eine Leistungshalbleiterschaltung tragendes Substrat an fünf Seiten umschließt. Der Grundkörper besteht vorzugsweise aus Kupfer wegen seiner hervorragenden Wärmeleitfähigkeit. Der Grundkörper ist direkt beispielhaft mittels einer Klebe- oder Schraubverbindung mit einem Kühlkörper verbindbar.

Nachteilig an einem derartigen Leistungshalbleitermodul ist die durch die Verbindung zwischen Grundplatte und Kühlkörper bedingte, suboptimale Wärmeübertragung von der Leistungshalbleiterschaltung zum Kühlkörper.

Weiterhin ist beispielhaft aus der US 008/0130223 A1 und ähnlich auch aus der US 2010/0208427 A1 und der US 2001/0014029 A1 ein Leistungshalbleitersystem bekannt das einem Metallformkörper mit einem Leitungssystem für ein fluides Arbeitsmedium zur Kühlung einer Leistungshalbleiterschaltung aufweist. Das Leitungssystem weist eine Mehrzahl von Hohlräumen im Metallformkörper auf, die durch Wandelemente verschlossen sind, wobei auf einer dem zugeordneten Hohlraum abgewandten Außenseite des Wandelements die Leistungshalbleiterschaltung angeordnet ist. Das Leistungshalbleitersystem der US 2008/0130233 A1 weist weiterhin einen mit der Leistungshalbleiterschaltung schaltungsgerecht verbundenen Kondensator auf.

Vor diesem Hintergrund liegt der Erfindung die Aufgabe zugrunde, ein verbessertes Leistungshalbleitersystem vorzustellen, bei dem eine effiziente Wärmeübertragung von der Leistungshalbleiterschaltung an ein Kühlmedium möglich ist.

Die vorliegende Offenbarung schlägt unter anderem vor, eine Leistungshalbleiterschaltung an einer Außenwand eines Wandelements anzuordnen, dessen Innenwand eine flüssigkeits- bzw. gasdichte Wand eines zur Kühlung der Halbleiterschaltung vorgesehenen, ein fluides Arbeitsmedium führenden Leitungssystems bildet. Hierdurch wird eine hervorragende Kühlung der Leistungshalbleiterschaltung erreicht.

Das erfindungsgemäße Leistungshalbleitersystem weist ein Leitungssystem für ein fluides Arbeitsmedium - beispielsweise eine Kühlflüssigkeit oder ein Kühlgas - auf. Das Leitungssystem kann ein geschlossenes Leitungssystem sein oder ein mit Ausnahme einer Einlassöffnung und einer Auslassöffnung geschlossenes Leitungssystem bilden. Hierdurch wird ein unerwünschtes Entweichen des Arbeitsmediums verhindert. Die Ein- und Auslassöffnungen können auf der gleichen Seite, vorzugsweise einer Stirnseite des Metallformkörpers angeordnet sein. Die Ein- und Auslassöffnungen können dazu dienen, das Leitungssystem an ein Pumpensystem anzuschließen. Das Leitungssystem kann an ein Pumpensystem angeschlossen sein, um das Arbeitsmedium durch das Leitungssystem zu pumpen. Dabei kann das Leitungssystem mit dem Pumpensystem ein geschlossenes Leitungssystem bilden. Eine Zirkulation des Arbeitsmediums innerhalb des Leitungssystems zum Abtransport von Wärme kann sowohl passiv aufgrund der Erwärmung des Arbeitsmediums - beispielsweise in Form eines Thermosiphons oder einer so genannten Heatpipe - als auch aktiv - beispielsweise durch ein wie oben beschriebenes Pumpensystem - erfolgen. Das Arbeitsmedium kann frei gewählt werden. Das Arbeitsmedium kann unter Normalbedingungen gasförmig oder flüssig sein. Geeignete Arbeitsmedien sind dem Fachmann für Thermosiphon und Heatpipes bekannt. Hierzu gehören unter anderem Wasser, Öl, Ethanol, Aceton und Ammoniak oder auch Gemische hieraus. Beim Wärmetransport innerhalb des Leitungssystems kann das Arbeitsmedium zwischen einem flüssigen und einem gasförmigen Zustand wechseln.

Das Leistungshalbleitersystem weist ein Wandelement mit einer Außenseite und einer Innenseite auf. Die Außenseite kann als eine dem Leitungssystem im Wesentlichen abgewandte Seite des Wandelements und die Innenseite als eine dem Leitungssystem im Wesentlichen zugewandte Seite des Wandelements verstanden werden. Dabei können die Innenseite und die Außenseite des Wandelements die Hauptflächen des Wandelements bilden. Die Innen- und Außenseiten können -jeweils individuell - plan oder strukturiert ausgebildet sein. Zum Beispiel kann die Oberseite mindestens ein Strukturelement zur Befestigung einer Leistungshalbleiterschaltung aufweisen.

Das Wandelement kann plattenförmig sein oder im Wesentlichen plattenförmig sein oder mindestens eine im Wesentlichen plattenförmigen Abschnitt aufweisen, der ein wesentliches Element des Wandelements bildet. Hierbei ist "wesentlich" dahingehend zu verstehen, dass die beschriebene Funktionalität des Wandelements - sofern diese Funktionalität für die jeweilige Ausführungsform des Wandelements nicht optional ist - zumindest teilweise durch das Element bzw. den Abschnitt gewährleistet wird. Bei einem im Wesentlichen plattenförmigen Wandelement ist ein Abstand zwischen Innen- und Außenseite des Wandelements im Verhältnis zur Länge des Wandelements gering, beispielsweise unter 10% oder unter 5% der Länge des Wandelements. Ähnlich ist im Bereich des plattenförmigen Abschnitts ein Abstand zwischen Innen- und Außenseite des Wandelements im Verhältnis zur Länge des plattenförmigen Abschnitts gering, beispielsweise unter 10% oder unter 5% der Länge des plattenförmigen Abschnitts. Durch diesen zumindestteilweise geringen Abstand wird eine gute Wärmeleitfähigkeit zwischen Innen- und Außenseite erreicht. Durch eine, zumindest teilweise, plattenförmige Form wird mit geringem Materialverbrauch ein gutes Verhältnis zwischen Wärmeübertragungsfläche und Abstand zwischen Innen- und Außenseite erreicht.

Das Leistungshalbleitersystem weist eine an der Außenseite des Wandelements angeordnete Leistungshalbleiterschaltung auf. Bei geeigneter Wahl der Form und/oder der Größe des Wandelements kann eine einfache und/oder automatisierte und/oder sichere Montage der Leistungshalbleiterschaltung an der Außenseite des Wandelements begünstigt werden. Zudem kann das Wandelement der Leistungshalbleiterschaltung eine Stabilität verleihen, die die Leistungshalbleiterschaltung bei einem späteren Zusammenbau des Wandelements mit dem Leitungssystem schützt. Dies kommt insbesondere dann zum Tragen, wenn eine Leistungshalbleiterschaltung nach Inbetriebnahme der Leistungshalbleiterschaltung, d.h. am Einsatzort, ausgetauscht werden soll.

Eine Leistungshalbleiterschaltung im Sinne der vorliegenden Offenbarung kann eine Schaltung mit mindestens einem Halbleiterbauelement mit einer Nennspannung von über 100 V oder gar über 600 V sein. Eine Leistungshalbleiterschaltung im Sinne der vorliegenden Offenbarung kann eine Schaltung sein, mit der ein Strompfad zwischen einem ersten Potential und einem zweiten Potential in Abhängigkeit von mindestens einem Steuersignal selektiv zwischen einem im Wesentlichen geschlossenen (niederohmigen) Zustand und einem im Wesentlichen offenen (hochohmigen) Zustand geschaltet werden kann, wobei eine Differenz zwischen dem ersten Potential und dem zweiten Potential mehr als 100 V oder gar mehr als 600 V beträgt oder wobei ein im geschlossenen Zustand regelmäßig über den Strompfad fließender Strom mehr als 100 A oder gar mehr als 1000 A beträgt.

Gemäß der Lehre der vorliegenden Offenbarung bildet die Innenseite des Wandelements eine flüssigkeits- bzw. gasdichte Wand des Leitungssystems. Auf diese Weise kann erreicht werden, dass die Leistungshalbleiterschaltung sehr nah zu einem im Leitungssystem vorgesehenen, fluiden Arbeitsmedium angeordnet ist, wodurch der Wärmeübergang zwischen der Leistungshalbleiterschaltung und dem fluiden Arbeitsmedium und folglich auch der Abtransport der in der Leistungshalbleiterschaltung entstehenden Abwärme begünstigt wird. Ob die Innenseite des Wandelements eine gasdichte Wand des Leitungssystems oder lediglich eine flüssigkeitsdichte Wand des Leitungssystems bilden soll, hängt vom verwendeten Arbeitsmedium und von den zu erwartenden Betriebsumständen ab. Wenn zu erwarten ist, dass das Arbeitsmedium einen gasförmigen Zustand einnehmen kann, soll die Innenseite des Wandelements Gasdichtigkeit aufweisen.

Das Leistungshalbleitersystem kann einen Metallformkörper - beispielsweise einen ganz oder teilweise aus Kupfer und/oder Aluminium hergestellten Metallformkörper - aufweisen, der ein vom Wandelement separates oder separierbares Gebilde ist. Hierbei ist es bevorzugt, wenn der Metallformkörper und das Wandelement aus dem gleichen Werkstoff, vorzugsweise Aluminium, ausgebildet sind. Das Wandelement kann kraft- und/oder formschlüssig am Metallformkörper befestigt sein. Hierbei sind bekannte Schraubverbindungen, Schnapp-Rastverbindungen oder auch Verbindungen, die durch Deformation eines Abschnitts des Wandelements und/oder des Metallformkörpers ausgebildet werden, bevorzugt. Aufgrund seiner allgemein guten Wärmeleitfähigkeit ist Metall ein geeignetes Material, um Abwärme fortzuleiten, die beispielsweise aufgrund eines Temperaturgradienten von einer Leistungshalbleiterschaltung zum Metallformkörper transportiert wurde. Der Metallformkörper kann als Kühlkörper, beispielsweise als gerippter Kühlkörper, gebildet sein.

Das Leitungssystem kann in und/oder am Metallformkörper angeordnet sein. Ein derartiger Metallformkörper wird häufig - unabhängig davon, ob das Arbeitsmedium flüssig oder gasförmig ist - als flüssigkeitsgekühlter Kühlkörper bezeichnet und ist in der Lage, große Mengen an Abwärme vom Metallformkörper abzutransportieren, da das Arbeitsmedium als Wärmetransportmittel dient. Insbesondere kann ein Teil des Leitungssystems durch Hohlräume im Metallformkörper - beispielsweise durch Bohrungen- gebildet sein. Hierdurch wird eine Übertragung von Wärme vom Metallformkörper zum Arbeitsmedium begünstigt. Der Metallformkörper weist auch eine Vertiefung auf in der ein Kondensator angeordnet ist, der mittels eines Vergussmaterials gegenüber dem Metallformkörper elektrisch isoliert wird. Auf diese Weise kann der Metallformkörper als Kühlkörper und als Träger für verschiedene Leistungshalbleiterkomponenten dienen.

Der Metallformkörper kann einen einen Teil des Leitungssystems bildenden ersten Hohlraum aufweisen, der eine Öffnung an mindestens einer Oberfläche des Metallformkörpers aufweist. Das Wandelement kann derart am Metallformkörper montiert sein, dass die Innenseite des Wandelements die Öffnung flüssigkeits- bzw. gasdicht verschließt. Ein derartiger Hohlraum lässt sich einfach herstellen, beispielsweise durch Verwendung einer entsprechenden Gießform zur Herstellung des Metallformkörpers oder durch Bohren oder Fräsen eines Metallformkörpers. Ebenso einfach lässt sich die Öffnung aufgrund der Flüssigkeits- bzw. Gasdichtigkeit der Innenseite des Wandelements verschließen. Zum Beispiel kann die Innenseite des Wandelements die Öffnung vollständig abdecken und die Öffnung nach außen hin durch direkten Kontakt mit dem Metallformkörper am gesamten Umfang der Öffnung, vorzugsweise mittels eines elastischen Dichtungselements, entlang flüssigkeits- bzw. gasdicht abdichten. Das Wandelement kann dabei auf einer Außenfläche des Metallformkörpers aufliegen oder innerhalb der Öffnung - beispielsweise entlang einem am inneren Umfang der Öffnung vorgesehenen Steg - eine gas- bzw. flüssigkeitsdichte Verbindung mit dem Metallformkörper herstellen. Folglich bildet die Öffnung- zusammen mit anderen im Metallformkörper vorgesehenen Hohlräumen - einen Teil des Leitungssystems. Ein Arbeitsmedium, das in den ersten Hohlraum strömt, kann in direkten Kontakt mit der Innenseite des Wandelements kommen.

Das Leistungshalbleitersystem kann ein elastisches Dichtungselement - beispielsweise einen O-Ring - aufweisen. Das Dichtungselement - das auch aus vielen einzelnen Dichtungselemente gebildet sein kann - kann mit dem Wandelement - beispielsweise mit der Innenseite des Wandelements - zusammenwirken, um eine wie oben beschriebene Öffnung an mindestens einer Oberfläche des Metallformkörpers flüssigkeits- bzw. gasdicht zu verschließen. Zum Beispiel kann das Wandelement am Metallformkörper befestigt sein und das Dichtungselement in notorischer Weise derart zwischen dem Wandelement und dem Metallformkörper geklemmt und um die Öffnung herum angeordnet sein, dass die Öffnung flüssigkeits- bzw. gasdicht verschlossen wird. Zum Beispiel kann das Dichtungselement im Bereich eines inneren Umfangs der Öffnung angeordnet sein. Das Dichtungselement kann benachbart zu einem Umfang der Öffnung - beispielsweise entlang einem am inneren Umfang der Öffnung vorgesehenen Steg - um die Öffnung herum verlaufen. Dabei kann sich das Dichtungselement innerhalb oder außerhalb der Öffnung befinden. Die Verwendung eines elastischen Dichtungselements kann die Gefahr einer Beschädigung der Leistungshalbleiterschaltung während der Montage des Wandelements am Metallformkörper verringern, da eine vergleichsweise geringere Kraft am Wandelement zur Gewährleistung der Dichtigkeit ausgeübt werden muss.

Der oben erwähnte erste Hohlraum im Metallformkörper kann eine erste Öffnung, die mit einem einlassseitigen Abschnitt des Leitungssystems verbunden ist, und/oder eine zweite Öffnung, die mit einem auslassseitigen Abschnitt des Leitungssystems verbunden ist, aufweisen. Auf diese Weise kann gewährleistet werden, dass das Arbeitsmedium durch den ersten Hohlraum zumindest zwischen der ersten und der zweiten Öffnung strömt. Aus diesem Grund kann der Hohlraum eine längliche Form aufweisen, bei der die erste Öffnung sich einem äußersten Drittel und die zweite Öffnung sich in einem der ersten Öffnung entgegengesetzten äußersten Drittel der Länge der Hohlraum befindet. Die erste und die zweite Öffnung können sich jeweils über mehr als 60% oder mehr als 80% der Breite des Hohlraums erstrecken. Hierdurch wird eine Strömung des Arbeitsmediums durch einen Großteil des Hohlraums sichergestellt. Der einlassseitige und/oder der auslassseitige Abschnitt des Leitungssystems kann jeweils durch eine einzelne Bohrung gebildet sind. Zum Beispiel kann der einlassseitige und/oder der auslassseitige Abschnitt des Leitungssystems durch eine Bohrung im Metallformkörper gebildet sein, die quer zur Länge des ersten Hohlraums verläuft. Die erste bzw. zweite Öffnung kann folglich dadurch hergestellt werden, dass der Hohlraum bis zur Bohrung in eine Fläche des Metallformkörpers gefräst wird. An der Schnittstelle zwischen dem Hohlraum und der Bohrung entsteht ohne weiteres Zutun die erste bzw. zweite Bohrung. Es können mehrere Hohlräume derart parallel zu einander im Metallformkörper geformt werden, dass die Hohlräume lediglich hinsichtlich ihrer Längsachsen jeweils gegeneinander versetzt sind. Auf diese Weise kann eine einzelne Bohrung als einlassbzw. auslassseitiger Abschnitt des Leitungssystems für sämtliche Hohlräume fungieren.

Der Metallformkörper kann eine Einlassöffnung und eine Auslassöffnung aufweisen. Das Leitungssystem kann sich flüssigkeits- bzw. gasdicht zwischen der Einlassöffnung und der Auslassöffnung erstrecken. Für eine gute Anbindung an ein weiteres Leitungssystem - beispielsweise an das Leitungssystem eines Pumpensystems - ist es hilfreich, wenn der Metallformkörper eine definierte Einlassöffnung und eine definierte Auslassöffnung aufweist. Zum Beispiel kann der Metallformkörper lediglich eine einzelne Einlassöffnung und/oder lediglich eine einzelne Auslassöffnung aufweisen. Hierdurch wird es auch einfacher, die Flüssigkeits- bzw. Gasdichtigkeit des Leitungssystems zu gewährleisten. Ob das Leitungssystem gasdicht oder lediglich flüssigkeitsdicht zwischen der Einlassöffnung und der Auslassöffnung erstrecken soll, hängt vom verwendeten Arbeitsmedium und von den zu erwartenden Betriebsumständen ab. Wenn zu erwarten ist, dass das Arbeitsmedium einen gasförmigen Zustand einnehmen kann, soll das Leitungssystem Gasdichtigkeit aufweisen.

Das Leistungshalbleitersystem kann einen am Metallformkörper befestigten Rahmen aufweisen. Der Rahmen kann das Wandelement kraft- und/oder formschlüssig am Metallformkörper befestigen. Zum Beispiel kann der Rahmen das Wandelement gegen den Metallformkörper drücken. Die Verwendung eines Rahmens erlaubt eine gleichzeitige Krafteinwirkung auf verschiedene Stellen des Wandelements. Hierdurch kann die Wahrscheinlichkeit einer schädlichen mechanischen Verformung der am Wandelement angeordneten Leistungshableiterschaltung reduziert werden. Der Rahmen kann aus einem elektrisch isolierenden Material - beispielsweise aus Kunststoff - sein. Der Rahmen kann auch - mindestens größtenteils - aus einem elektrisch leitenden Material - beispielsweise Metall - sein, das mittels eines elektrisch isolierenden Materials gegenüber den stromführenden Elementen der Leistungshalbleiterschaltung elektrisch isoliert ist. Der Rahmen kann so gebildet sein, dass der Rahmen lediglich in einem äußeren Randbereich der Außenseite des Wandelements am Wandelement aufliegt. Der Rahmen kann mittels einer automatisiert herstellbaren Verbindung - beispielsweise mittels einer Schraubverbindung oder einer Schnappverbindung - am Metallformkörper befestigt sein. Hierdurch wird eine automatisierte Montage des Wandelements und des Rahmens begünstigt.

Die stromführenden Elemente der Leistungshalbleiterschaltung können gegenüber der Innenseite desjenigen Wandelements elektrisch isoliert sein, an der die Leistungshalbleiterschaltung angeordnet ist. Auf diese Weise wird vermieden, dass ein unerwünschter Strompfad zwischen der Leistungshalbleiterschaltung und einem anderem Element des Leistungshalbleitersystems - beispielsweise dem Metallformkörper und/oder dem Arbeitsmedium - entsteht.

Die Leistungshalbleiterschaltung kann ein in fachnotorischer Weise mit Leistungshalbleitern bestücktess Substrat aufweisen.

Der metallische Kühlkörper des Wandelements kann als einfache Metallplatte oder als Metallplatte mit senkrecht oder im Wesentlichen senkrecht zu einer Hauptfläche der Metallfläche abstehenden Kühlrippen oder Kühlstifte ausgebildet sein. Die Kühlrippen und/oder die Kühlstifte können eine Vergrößerung einer wärmeabgebenden Fläche des Kühlkörpers bewirken.

Das Leitungssystem kann mit einem fluiden Arbeitsmedium gefüllt sein. Das Arbeitsmedium kann die Innenseite des Wandelements mit dem Arbeitsmedium in Berührung sein. Durch eine direkte Berührung der Innenseite des Wandelements durch das Arbeitsmedium wird ein sehr guter Abtransport der von der Leistungshalbleiterschaltung erzeugten Abwärme erreicht.

Das Leistungshalbleitersystem kann mehrere wie oben beschriebene erste Hohlräume aufweisen. Das Leistungshalbleitersystem kann mehrere wie oben beschriebene Wandelemente aufweisen. Mehrere oder alle der durch die einzelnen Hohlräume an mindestens einer Oberfläche des Metallformkörpers gebildeten, einzelnen Öffnungen können durch ein einziges Wandelement flüssigkeits- bzw. gasdicht verschlossen sein. Gleichwohl können einzelne der einzelnen Öffnungen jeweils durch einzelne Wandelemente flüssigkeits- bzw. gasdicht verschlossen sein. Das Leistungshalbleitersystem kann einen wie oben beschriebenen Rahmen aufweisen, der mehrere Wandelemente - beispielsweise in der oben beschriebenen Weise - gegen den Metallformkörper drückt.

Nachfolgend wird die Erfindung anhand von Ausführungsbeispielen beschrieben, die anhand der Abbildungen näher erläutert werden. Hierbei zeigen:

- Figur 1: eine perspektivische Ansicht eines Metallformkörpers für ein Leistungshalbleitersystem gemäß einer ersten Ausführungsform;
- Figur 2: eine perspektivische Ansicht eines Leistungshalbleitersystems gemäß einer zweiten Ausführungsform;
- Figur 3: eine perspektivische Ansicht eines Leistungshalbleitersystems gemäß einer dritten Ausführungsform;
- Figur 4: ein Leistungshalbleitersystems gemäß einer vierten Ausführungsform;
- Figur 5: eine schematische Schnittdarstellung eines Leistungshalbleitersystems gemäß einer vierten Ausführungsform; und
- Figur 6: eine schematische Schnittdarstellung eines Leistungshalbleitersystems gemäß einer sechsten Ausführungsform.

In der nachfolgenden Beschreibung werden für gleiche und gleich wirkende Teile dieselben Bezugsziffern verwendet.

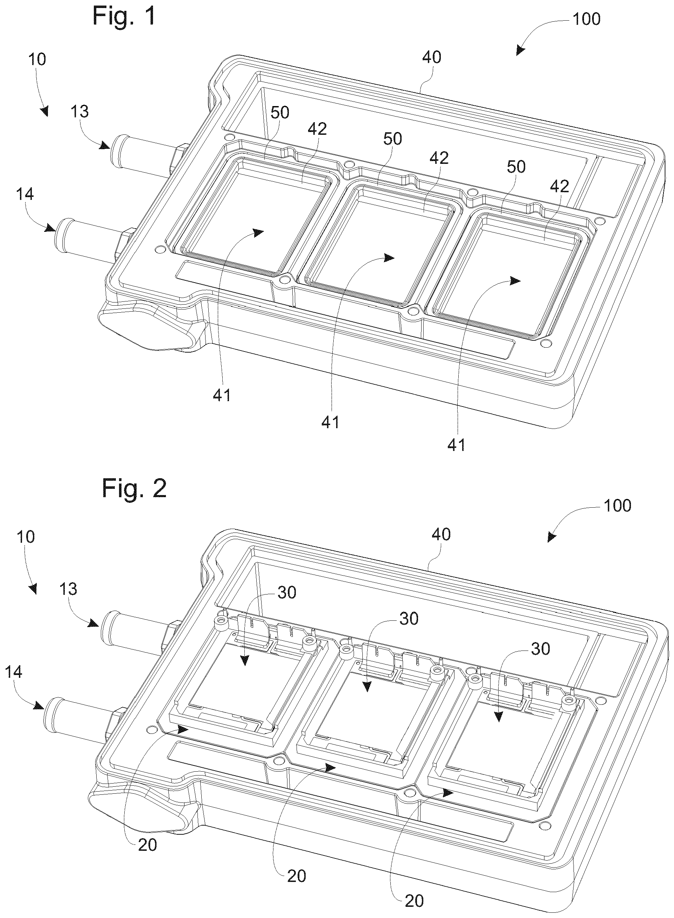

Die Figur 1 zeigt eine perspektivische Ansicht eines Metallformkörpers 40 für ein Leistungshalbleitersystem 100 gemäß einer ersten Ausführungsform. Der Metallformkörper ist als Kühlkörper für eine Leistungshalbleiterschaltung dargestellt, der durch ein fluides Arbeitsmedium gekühlt werden kann. Der Metallformkörper 40 weist mehrere in etwa rechteckigen Hohlräume 41 und mehrere Öffnungen 42 dieser auf. Für die Zu- und Abfuhr des Arbeitsmediums sind Ein- und Auslassöffnungen 13, 14 vorgesehen. Die Einlassöffnung ist über die jeweiligen Öffnungen 42 mit den jeweiligen Hohlräumen 41 des Metallformkörpers 40 derart verbunden, dass die Hohlräume 41 mit der Einlassöffnung 13 ein Leitungssystem 10 für das fluide Arbeitsmedium bilden. Die Öffnungen 43, über die - ähnlich wie die Öffnungen 42 - die Hohlräume 41 für das fluide Arbeitsmedium mit der Auslassöffnung 14 verbunden sind, sind in der Figur 1 nicht gezeigt. Das Arbeitsmedium, das in die Einlassöffnung 13 strömt, fließt folglich über die Öffnungen 42 durch den Hohlraum 41 und anschließend zur Auslassöffnung 14. Um den jeweiligen Hohlraum 41 herum ist ein jeweiliges Dichtungselement 50 angeordnet, das mit einem eine Leistungshalbleiterschaltung 30 tragenden, in der Figur 1 nicht gezeigten Wandelement 20 zusammenwirkt, um die jeweiligen Öffnungen, die die jeweiligen Hohlräume 41 in der oberen Fläche des Metallformkörpers bilden, flüssigkeits- oder gasdicht zu verschließen.

Die Figur 2 zeigt eine perspektivische Ansicht eines Leistungshalbleitersystems 100 gemäß einer zweiten Ausführungsform. Die in der Figur 2 gezeigte Ausführungsform weist auch einen wie in der Figur 1 gezeigten Metallformkörper 40 mit den oben beschriebenen Merkmalen auf. Das in der Figur 2 dargestellte Leistungshalbleitersystem 100 weist auch mehrere Wandelemente 20 auf. An der dem Metallformkörper 40 abgewandten Außenseite des jeweiligen Wandelements 20 ist eine Leistungshalbleiterschaltung 30 angeordnet. Jedes der Wandelemente 20 deckt einen der in der Darstellung der Figur 2 wegen der Abdeckung durch das jeweilige Wandelement 20 nicht sichtbaren Hohlraum 41 ab, wodurch die jeweilige Öffnung, die den jeweilig abgedeckten Hohlraum 41 in der oberen Fläche des Metallformkörpers 40 bildet, flüssigkeits- oder gasdicht zu verschließen. Eine in der Darstellung der Figur 2 nicht sichtbare Innenseite 22 des jeweiligen Wandelements 20 bildet dabei eine flüssigkeits- bzw. gasdichte Wand des oben erwähnten Leitungssystems 10. Diese Innenseiten 22 haben direkten Kontakt mit dem durch das Leitungssystem 10 fließenden fluiden Arbeitsmedium, was eine sehr gute Kühlung der Wandelemente 20 und folglich auch der an der Außenseite der Wandelemente 20 angeordneten Leistungshalbleiterschaltungen 30 bewirkt.

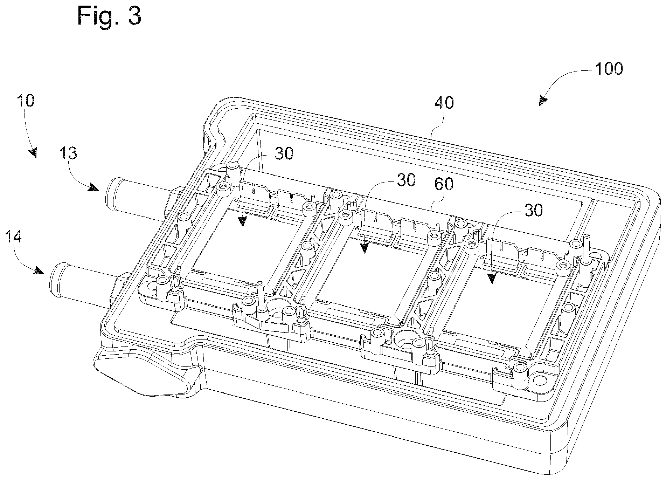

Die Figur 3 zeigt eine perspektivische Ansicht eines Leistungshalbleitersystems 100 gemäß einer dritten Ausführungsform. Die in der Figur 3 gezeigte Ausführungsform weist auch ein wie in der Figur 2 gezeigtes Leistungshalbleitersystem 100 mit den oben beschriebenen Merkmalen auf. Das in der Figur 3 dargestellte Leistungshalbleitersystem 100 weist zusätzlich einen Kunststoffrahmen 60 auf, der am Metallformkörper 40 befestigt ist. Der Kunststoffrahmen 60 umgibt die - in der Figur 3 nicht sichtbaren - einzelnen Wandelemente 20 derart, dass die jeweilige Außenseite der einzelnen Wandelemente 20 nur geringfügig - beispielsweise zu weniger als 10% oder weniger als 5% - vom Kunststoffrahmen abgedeckt ist. Gleichzeitige drückt der Kunststoffrahmen 60 die Wandelemente 20 gegen die Dichtungselemente 50 in Richtung des Metallformkörpers 40, wodurch die Wandelemente 20 mit den Dichtungselemente 50 zusammenwirken, um die durch den Hohlraum 41 in der oberen Fläche des Metallformkörpers 40 gebildeten Öffnungen flüssigkeits- bzw. gasdicht zu verschließen. Die Verwendung eines einzelnen Rahmens 60 vereinfacht die Montage.

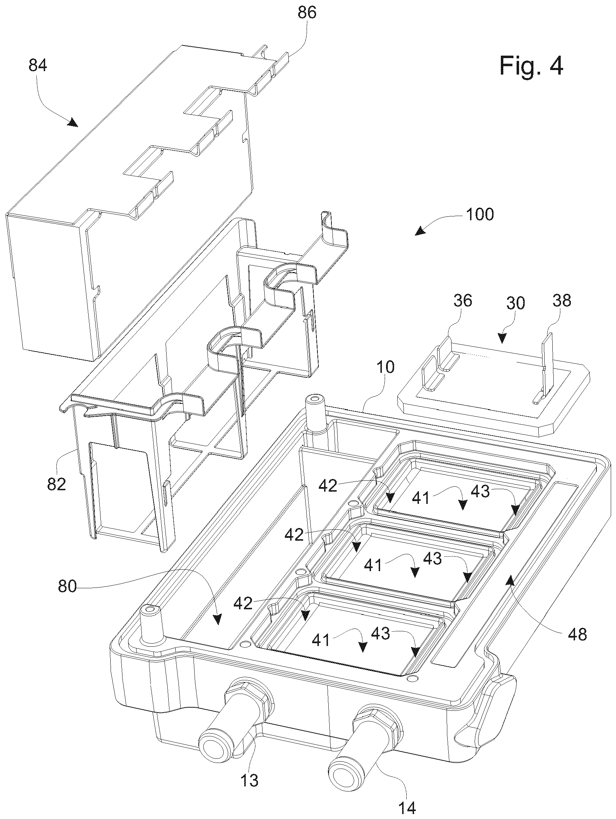

Die Figur 4 zeigt eine schematische Explosionszeichnung eines Leistungshalbleitersystems 100 gemäß einer vierten Ausführungsform. Gegenüber der Ausführungsform nach Figur 1, ist hier ein zusätzliches Kondensatormodul mit einem ungehausten Kondensator 84 und einen aus einem elektrisch isolierenden Material gefertigten Abstandshalter 82 zur Anordnung des Kondensators 84 in einer Vertiefung 80 des Metallformkörpers 40 zusätzlich dargestellt. Zur elektrischen Isolierung des Kondensators 84 gegenüber dem Metallformkörper 40 ist zusätzlich eine nicht dargestellte Vergussmasse in der Vertiefung 80 vorgesehen.

Durch dieses eng benachbarte Anordnung des Kondensators 84 zu den Hohlräumen 41 bzw. den Wandelementen 20 kann dieser Kondensator 84 gleichzeitig mit den Leistungsschaltungen gekühlt werden. Ebenfalls erkennbar ist die unmittelbare Möglichkeit der Verbindung des Kondensators 84 mit dessen Anschlusselementen 86 zu denjenigen zugeordneten Anschlusselementen 36 der Leistungsschaltung 30. Hierbei ist es bevorzugt, wenn die jeweiligen Anschlusselemente 36 derart aufgebaut und zueinander angeordnet sind, dass eine Schweißverbindung ausgebildet werden kann. Hierzu weist das Leistungshalbleitersystem 100 einen ausreichenden Freiraum auf um mit einer Schweißeinrichtung die beiden Anschlusselement 36, 86 erreichen zu können.

Es kann auch bevorzugt sein, wenn die Anschlusselemente 86 des Kondensators 84 und die zugeordneten Anschlusselemente 36 der Leistungsschaltung 30 nicht dauerhaft stoffschlüssig, sondern lösbar, bevorzugt kraftschlüssig miteinander verbunden sind.

Weiterhin und unabhängig von den bisher beschriebenen Merkmalen kann es vorteilhaft sein, wenn wie hier dargestellt, der Metallformkörper 40 ein weitere Ausnehmung 48 aufweist um dort ein nicht dargestelltes externes Verbindungselement anzuordnen und dieses jeweils und schaltungsgerecht mit weiteren Anschlusselementen 38 der Leistungsschaltung 30 zu verbinden. Es ist bevorzugt, wenn diese Ausnehmung 48 seitlich zu den Leistungsschaltungen 40 bzw. den zugeordneten Wandelementen 20 gegenüber dem Kondensator 84 vorgesehen ist. Diese Ausnehmung 48 reicht von derjenigen Hauptseite des Metallformkörpers 40 auf der die Wandelemente 20 vorgesehen sind zu der gegenüberliegenden Hauptseite.

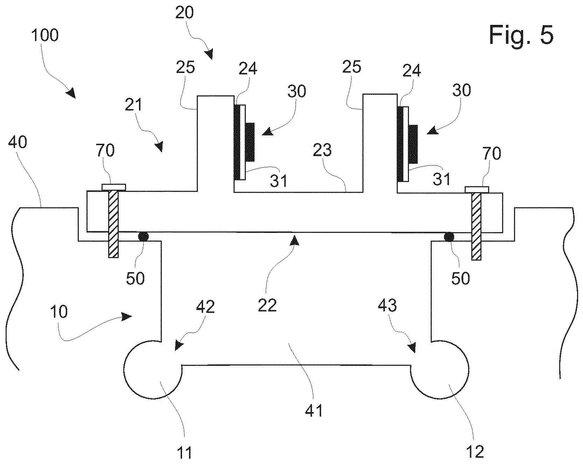

Die Figur 5 zeigt eine schematische Schnittdarstellung eines Leistungshalbleitersystems 100 gemäß einer fünften Ausführungsform. Das dargestellte Leistungshalbleitersystem 100 weist ein Leitungssystem 10, ein Wandelement 20, mehrere Leistungshalbleiterschaltungen 30, einen Metallformkörper 40 und ein Dichtungselement 50 auf.

Das Leitungssystem 10 ist zur Führung eines als Kühlflüssigkeit dienenden, fluiden Arbeitsmediums ausgebildet und weist einen einlassseitigen Abschnitt 11 und einen auslassseitigen Abschnitt 12 auf, die jeweils mit einer in der Figur 4 nicht gezeigten Ein- bzw. Auslassöffnung 13, 14 verbunden sind.

Das Wandelement 20 hat eine im Wesentlichen dem Leitungssystem abgewandte Außenseite 21 und eine im Wesentlichen dem Leitungssystem zugewandte Innenseite 22. Das Wandelement 20 weist einen metallischen Kühlkörper 23, der in der hier dargestellten Ausführungsform die Innenseite 22 des Wandelements 20 bildet, und mehrere Substrate 31 auf. Der Kühlkörper 23 weist Vorsprünge 25 auf, die senkrecht von der Hauptfläche der Außenseite 21 des Wandelements 20 hervorstehen und an denen die Substrate 31 angeordnet sind.

Jede der Leistungshalbleiterschaltungen 30 weist ein mit Leistungshalbleitern bestücktes Substrat 31 auf, das zwecks elektrischer Isolierung des Substrats 31 gegenüber dem Kühlkörper 23 eine Keramikplatte 24 aufweist.

Der Metallformkörper 40 weist einen ersten Hohlraum 41 auf, der einen Teil des Leitungssystems 10 bildet. Der Hohlraum 41 kann dadurch gebildet sein, dass der Metallformkörper 40 entsprechend gefräst oder in einer entsprechenden Gussform hergestellt wird. Der Hohlraum 41 weist eine erste Öffnung 42, durch die das fluide Arbeitsmittel zwischen dem Hohlraum 41 und dem einlassseitigen Abschnitt 11 fließen kann, und eine zweite Öffnung 43, durch die das fluide Arbeitsmittel zwischen dem Hohlraum 41 und dem auslassseitigen Abschnitt 12 fließen kann. Die ein- und auslassseitigen Abschnitte 11, 12 können in einfacher Weise durch jeweilige Bohrungen im Metallformkörper gebildet sein. Die erste und zweite Öffnungen 42, 43 können in einfacher Weise dadurch gebildet werden, dass die Bohrungen dne Hohlraum 41 teilweise anschneiden.

Zwischen der Innenseite 22 des Wandelements 20 und dem Metallformkörper 40 ist das Dichtungselement 50 angeordnet. Das Wandelement wird mittels Schrauben 70 am Metallformkörper 40 befestigt. Das Dichtungselement wirkt mit der Innenseite 22 des Wandelements 20 in fachnotorischer Weise zusammen, um die durch den Hohlraum 41 in der oberen Fläche des Metallformkörpers 40 gebildete Öffnung flüssigkeits- bzw. gasdicht zu verschließen. Somit bildet die Innenseite 22 des Wandelements 20 eine Wand des Leitungssystems 10.

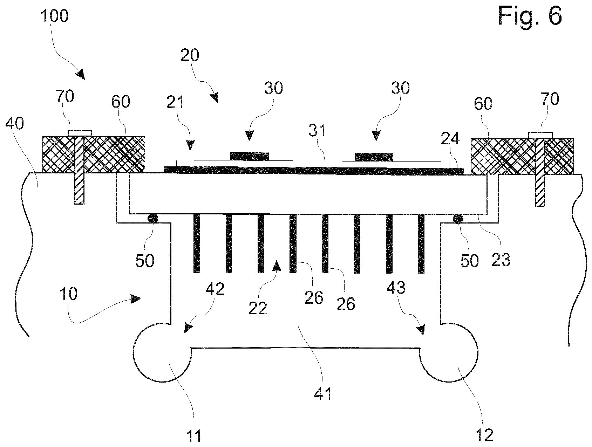

Die Figur 6 zeigt eine schematische Schnittdarstellung eines Leistungshalbleitersystems 100 gemäß einer sechsten Ausführungsform. Das dargestellte Leistungshalbleitersystem 100 weist ein Leitungssystem 10, ein Wandelement 20, mehrere Leistungshalbleiterschaltungen 30, einen Metallformkörper 40, ein Dichtungselement 50 und einen Rahmen 60 auf.

Das Leitungssystem 10 ist zur Führung eines als Kühlflüssigkeit dienenden, fluiden Arbeitsmediums ausgebildet und weist einen einlassseitigen Abschnitt 11 und einen auslassseitigen Abschnitt 12 auf, die jeweils mit einer Ein- bzw. Auslassöffnung 13, 14 verbunden sind.

Das Wandelement 20 hat eine im Wesentlichen dem Leitungssystem abgewandte Außenseite 21 und eine im Wesentlichen dem Leitungssystem zugewandte Innenseite 22. Das Wandelement 20 weist einen metallischen Kühlkörper 23, der hier dargestellten Ausführungsform die Innenseite 22 des Wandelements 20 bildet. Der Kühlkörper 23 weist Stifte 26 auf, die senkrecht von der Hauptfläche der Innenseite 22 des Wandelements 20 hervorstehen und die die wärmeabgebende Fläche der Innenseite 22 des Wandelements 20 vergrößern.

Jede der Leistungshalbleiterschaltungen 30 weist ein mit Leistungshalbleitern bestücktes Substrat 31 auf, das zwecks elektrischer Isolierung gegenüber dem Kühlkörper 23 eine Keramikplatte 24 aufweist.

Der Metallformkörper 40 weist einen Hohlraum 41 auf, der einen Teil des Leitungssystems 10 bildet. Dieser Hohlraum 41 kann dadurch gebildet sein, dass der Metallformkörper 40 entsprechend gefräst oder in einer entsprechenden Gussform hergestellt wird. Die Hohlraum 41 weist eine erste Öffnung 42, durch die das fluide Arbeitsmittel zwischen dem Hohlraum 41 und dem einlassseitigen Abschnitt 11 fließen kann, und eine zweite Öffnung 43, durch die das fluide Arbeitsmittel zwischen dem Hohlraum 41 und dem auslassseitigen Abschnitt 12 fließen kann. Die ein- und auslassseitigen Abschnitte 11, 12 können in einfacher Weise durch jeweilige Bohrungen im Metallformkörper gebildet sein. Die erste und zweite Öffnungen 42, 43 können in einfacher Weise dadurch gebildet werden, dass die Bohrungen den Hohlraum 41 teilweise anschneiden.

Zwischen der Innenseite 22 des Wandelements 20 und dem Metallformkörper 40 ist das Dichtungselement 50 angeordnet. Das Dichtungselement wirkt mit der Innenseite 22 des Wandelements 20 in fachnotorischer Weise zusammen, um die durch den Hohlraumen 41 in der oberen Fläche des Metallformkörpers 40 gebildete Öffnung flüssigkeits- bzw. gasdicht zu verschließen. Somit bildet die Innenseite 22 des Wandelements 20 eine Wand des Leitungssystems 10.

Der Rahmen 60, der aus einem nicht leitenden Material hergestellt sein kann und mittels Schrauben 70 am Metallformkörper befestigt ist, befestigt das Wandelement 20 am Metallformkörper 40. Dabei drückt der Rahmen 60 gegen die Außenseite 21 des Wandelements 20 und liegt lediglich in einem äußeren Randbereich der Außenseite 21 des Wandelements 20 am Wandelement 20 auf.

An dieser Stelle sei explizit darauf hingewiesen, dass die in den Figuren dargestellten Ausführungsformen in jede in dieser Offenbarung beschriebener Art abgewandelt werden können. An dieser Stelle sei zudem darauf hingewiesen, dass alle oben beschriebenen Merkmale für sich alleine gesehen und in jeder Kombination, insbesondere die in den Zeichnungen dargestellten Details als erfindungswesentlich beansprucht werden können. Abänderungen hiervon sind dem Fachmann geläufig.

## Patentansprüche

1. Leistungshalbleitersystem (100), mit einem Metallformkörper (40), mit mindestens einem Kondensator (84) und mit
einem Leitungssystem (10) für ein fluides Arbeitsmedium;
wobei ein Teil des Leitungssystems (10) durch eine Mehrzahl von ersten Hohlräumen (41) im Metallformkörper (40) gebildet ist;
mit mindestens einem Wandelement (20) mit einer Außenseite (21) und einer Innenseite (22); und
einer an der Außenseite (21) des Wandelements (20) angeordneten Leistungshalbleiterschaltung (30), wobei
die Innenseite (22) des Wandelements (20) eine flüssigkeits- bzw. gasdichte Wand des Leitungssystems (10) bildet, und wobei
der Metallformkörper (40) eine Vertiefung (80) für den mindestens einen direkt zu dem mindestens einen Wandelement (20) benachbart angeordneten und durch den Metallformkörper (40) gekühlten Kondensator (84) aufweist,
dadurch charakterisiert, dass
der mindestens eine Kondensator (84) ein ungehauster Kondensator ist und mittels eines Abstandshalters (82) und eines Vergussmittels in der Vertiefung (80) angeordnet ist.

2. Leistungshalbleitersystem (100) nach Anspruch 1, wobei
der Metallformkörper (40) mindestens einen, einen Teil des Leitungssystems (10) bildenden, ersten Hohlraum (41) aufweist, der eine Öffnung an einer Oberfläche des Metallformkörpers (40) bildet, und
das Wandelement (20) derart am Metallformkörper (40) montiert ist, dass die Innenseite (22) des Wandelements (20) die Öffnung flüssigkeits- bzw. gasdicht verschließt.

3. Leistungshalbleitersystem (100) nach Anspruch 2,
wobei die Innenseite (22) des Wandelements zum Metallformkörper (40) mittels eines elastischen Dichtungselements (50) verschlossen ist.

4. Leistungshalbleitersystem (100) nach Anspruch 2 oder 3, wobei der erste Hohlraum (41) eine erste Öffnung (42), die mit einem einlassseitigen Abschnitt (11) des Leitungssystems (10) verbunden ist, und eine zweite Öffnung (43), die mit einem auslassseitigen Abschnitt (12) des Leitungssystems (10) verbunden ist, aufweist.

5. Leistungshalbleitersystem (100) nach einem der Ansprüche 2-4, mit einem am Metallformkörper (40) befestigten Rahmen (60), der das Wandelement (20) form- und/oder kraftschlüssig am Metallformkörper (40) befestigt.

6. Leistungshalbleitersystem (100) nach einem der vorhergehenden Ansprüche, wobei
stromführende Elemente der Leistungshalbleiterschaltung (30) gegenüber der Innenseite (21) des Wandelements (20) elektrisch isoliert sind.

7. Leistungshalbleitersystem (100) nach einem der vorhergehenden Ansprüche, wobei
die Leistungshalbleiterschaltung (30) ein mit Leistungshalbleitern bestücktes Substrat (31) aufweist.

8. Leistungshalbleitersystem (100) nach Anspruch 1, wobei das Wandelement (20) als metallischer Kühlkörper (23) ausgebildet ist.

9. Leistungshalbleitersystem (100) nach Anspruch 8, wobei der Kühlkörper (23) Rippen und/oder Stifte (26) aufweist, die eine Vergrößerung einer wärmeabgebenden Fläche des Kühlkörpers (23) bewirken.

10. Leistungshalbleitersystem (100) nach einem der vorhergehenden Ansprüche, wobei
das Leitungssystem (10) mit einem fluiden Arbeitsmedium gefüllt ist, und
die Innenseite (22) des Wandelements (20) mit dem Arbeitsmedium in Berührung ist.

## Claims

1. Power semiconductor system (100), comprising a metal shaped body (40), comprising at least one capacitor (84) and comprising
a line system (10) for a fluid working medium; wherein a part of the line system (10) is formed by a plurality of first cavities (41) in the metal shaped body (40),
comprising
at least one wall element (20) having an outer side (21) and an inner side (22); and
a power semiconductor circuit (30) arranged at the outer side (21) of the wall element (20), wherein the inner side (22) of the wall element (20) forms a liquid- and/or gas-tight wall of the line system (100), and wherein
the metal shaped body (40) has a depression (80) for the at least one capacitor (84) which is arranged directly adjacent to the at least one wall element (20) and which is cooled by the metal shaped body (40),
**characterized in that**
the at least one capacitor (84) is an unhoused capacitor and is arranged by means of a spacer (82) and a potting agent in the depression (80).

2. Power semiconductor system (100) according to Claim 1, wherein
the metal shaped body (40) has at least one first cavity (41) which forms a part of the line system (10) and which forms an opening at a surface of the metal shaped body (40), and
the wall element (20) is mounted on the metal shaped body (40) in such a way that the inner side (22) of the wall element (20) closes off the opening in a liquid- and/or gas-tight manner.

3. Power semiconductor system (100) according to Claim 2,
wherein the inner side (22) of the wall element is closed off with respect to the metal shaped body (40) by means of an elastic sealing element (50).

4. Power semiconductor system (100) according to Claim 2 or 3, wherein
the first cavity (41) has a first opening (42), which is connected to an inlet-side section (11) of the line system (10), and a second opening (43), which is connected to an outlet-side section (12) of the line system (10).

5. Power semiconductor system (100) according to any of Claims 2-4, comprising
a frame (60) fixed to the metal shaped body (40), which frame fixes the wall element (20) to the metal shaped body (40) in a positively locking and/or force-locking fashion.

6. Power semiconductor system (100) according to any of the preceding claims, wherein
the current-carrying elements of the power semiconductor circuit (30) are electrically insulated from the inner side (21) of the wall element (20).

7. Power semiconductor system (100) according to any of the preceding claims, wherein
the power semiconductor circuit (30) has a substrate (31) equipped with power semiconductors.

8. Power semiconductor system (100) according to Claim 1, wherein
the wall element (20) is embodied as a metallic heat sink (23).

9. Power semiconductor system (100) according to Claim 8, wherein the heat sink (23) has ribs and/or pins (26) that bring about an enlargement of a heat-dissipating area of the heat sink (23).

10. Power semiconductor system (100) according to any of the preceding claims, wherein
the line system (10) is filled with a fluid working medium, and
the inner side (22) of the wall element (20) is in contact with the working medium.

## Revendications

1. Système (100) de semi-conducteur de puissance présentant un corps métallique moulé (40), au moins un condensateur (84) et un système (10) de conduits pour un fluide de travail,
une partie du système (10) de conduits étant formée par plusieurs premières cavités (41) ménagées dans le corps métallique moulé (40),
au moins un élément de paroi (20) présentant un côté extérieur (21) et un côté intérieur (22) et
un circuit (30) de semi-conducteur de puissance disposé sur le côté extérieur (21) de l'élément de paroi (20),
le côté intérieur (22) de l'élément de paroi (20) formant une paroi étanche aux liquides ou aux gaz du système (10) de conduits et
le corps métallique moulé (40) présentant un creux (80) pour le ou les condensateurs (84) disposés au voisinage direct du ou des éléments de paroi (20) et refroidis par le corps métallique moulé (40), **caractérisé en ce que**
le ou les condensateurs (84) sont des condensateurs non encapsulés et sont disposés dans le creux (80) au moyen d'un écarteur (82) et d'un agent d'enrobage.

2. Système (100) de semi-conducteur de puissance selon la revendication 1, dans lequel le corps métallique moulé (40) présente au moins une première cavité (41) formant une partie du système (10) du conduit et formant une ouverture sur une surface du corps métallique moulé (40) et en ce que l'élément de paroi (20) est monté sur le corps métallique moulé (40) de telle sorte que le côté intérieur (22) de l'élément de paroi (20) ferme l'ouverture de manière étanche aux liquides ou aux gaz.

3. Système (100) de semi-conducteur de puissance selon la revendication 2, dans lequel le côté intérieur (22) de l'élément de paroi est fermé vis-à-vis du corps métallique moulé (40) au moyen d'un élément élastique d'étanchéité (50).

4. Système (100) de semi-conducteur de puissance selon les revendications 2 ou 3, dans lequel la première cavité (41) présente une première ouverture (42) reliée à la section (11) côté admission du système (10) de conduits et une deuxième ouverture (43) reliée à une section (12) côté sortie du système (10) de conduits.

5. Système (100) de semi-conducteur de puissance selon l'une des revendications 2 à 4, présentant un cadre (60) fixé sur le corps métallique moulé (40) et qui fixe l'élément de paroi (20) en correspondance géométrique et/ou en correspondance mécanique sur le corps métallique moulé (40).

6. Système (100) de semi-conducteur de puissance selon l'une des revendications précédentes, dans lequel des éléments conduisant le courant du circuit semi-conducteur de puissance (30) sont isolés électriquement vis-à-vis du côté intérieur (21) de l'élément de paroi (20).

7. Système (100) de semi-conducteur de puissance selon l'une des revendications précédentes, dans lequel le circuit semi-conducteur de puissance (30) présente un substrat (31) équipé de semi-conducteurs de puissance.

8. Système (100) de semi-conducteur de puissance selon la revendication 1, dans lequel l'élément de paroi (20) est configuré comme corps métallique de refroidissement (23).

9. Système (100) de semi-conducteur de puissance selon la revendication 8, dans lequel le corps de refroidissement (23) présente des nervures et/ou des tiges (26) qui ont pour effet une augmentation de la surface émettrice de chaleur du corps de refroidissement (23).

10. Système (100) de semi-conducteur de puissance selon l'une des revendications précédentes, dans lequel le système (10) de conduits est rempli d'un fluide de travail et dans lequel le côté intérieur (22) de l'élément de paroi (20) est en contact avec le fluide de travail.
